# EUROPEAN PATENT APPLICATION

(11) **EP 4 438 750 A1**
(43) Date of publication of application: **02.10.2024**
(21) Application number: 22897274.1
(22) Date of filing: 30.08.2022
(51) Int. Cl.: C22B 7/00, C22B 1/02, C22B 23/00, C22B 26/12, C22B 47/00, C30B 7/14, C30B 28/04, C30B 29/46, C25C 3/06, C01D 15/08, H01M 10/54

(54) **METHOD FOR RECYCLING VALUABLE METAL IN LITHIUM BATTERY POSITIVE PLATE**

(30) Priority: 26.11.2021 CN 202111420708
(71) Applicant: Guangdong Brunp Recycling Technology Co., Ltd., Foshan, Guangdong 528137 (CN); Hunan Brunp Recycling Technology Co., Ltd., Changsha, Hunan 410600 (CN); Hunan Brunp EV Recycling Co., Ltd., Changsha, Hunan 410600 (CN)
(72) Inventor: OUYANG, Shibao, Foshan, Guangdong 528137 (CN); LI, Changdong, Foshan, Guangdong 528137 (CN); CHEN, Ruokui, Foshan, Guangdong 528137 (CN); FU, Xiongcong, Foshan, Guangdong 528137 (CN); RUAN, Dingshan, Foshan, Guangdong 528137 (CN); CAI, Yong, Foshan, Guangdong 528137 (CN)
(74) Representative: Studio Torta S.p.A.
(86) International application number: PCT/CN2022/115955
(87) International publication number: WO 2023/093182

(57) **Abstract**

Disclosed in the present invention is a method for recycling valuable metal in a lithium battery positive plate, comprising the following steps: S1, mixing a positive plate material with reducing metal, and then roasting, the roasting being carried out in a protective atmosphere; S2, performing magnetic separation on the material obtained in step S1 to obtain a magnetic component and a non-magnetic component; S3, performing acid dissolution on the magnetic component, concentrating the obtained leaching solution, and then performing cooling crystallization to obtain a metal salt A; and S4, performing water soaking on the non-magnetic component to obtain sediment and water soaking liquid, adding carbonate into the water soaking liquid to obtain lithium carbonate, performing acid dissolution on the sediment, purifying, and performing evaporative crystallization to obtain a dissolved solution to obtain a metal salt B. According to the recycling method of the present invention, the purpose of omitting extraction and accessory steps thereof can be achieved by means of simple impurity removal and separation processes, the technological process is simplified, and the investment cost is reduced.

## Description

### FIELD

The present disclosure relates to the field of solid waste recycling, and specifically relates to a recovery method of valuable metal in positive electrode sheet of a lithium battery.

### BACKGROUND

Due to the advantages of light weight and high energy density, lithium batteries have been widely used in digital electronic products, new energy vehicles and energy storage fields. In recent years, the vigorous development of the new energy industry has driven the demand for lithium batteries in the consumer market. According to statistics, in 2020, the annual output of pure electric vehicles in the mainland exceeded 2 million, and the cumulative production and sales volume reached 5 million. However, since the service life of lithium batteries is 5~8 years, with the booming of new energy industry, the waste batteries generated by scrapped products also reached 500,000 tons per year.

Waste lithium-ion batteries contain metal resources such as lithium, nickel, cobalt, manganese, iron, copper, and aluminum, as well as solid and liquid organics. If they are discarded at will, it will not only waste resources, but also pollute the environment, so it is necessary to recycle.

Traditional recycling of lithium batteries mainly includes two processes: pyrometallurgy and hydro metallurgy. The pyrometallurgy process is to first melt waste lithium batteries into alloys at a high temperature, and then leach and recover valuable metals in the obtained alloys. However, due to the high energy consumption, this process is less used. The hydrometallurgy recovery process mainly includes the following steps in sequence: discharging, dismantling, crushing, sorting, and screening of waste lithium batteries to obtain battery powder and by-products (copper-aluminum residue, diaphragm, etc.), and the battery powder is subjected to leaching, impurity removal, extraction and back-extraction processes to obtain a sulfate solution of nickel, cobalt and manganese, thereby realizing the recycling of valuable metals such as nickel, cobalt, and manganese.

However, the existing hydrometallurgy recovery process of waste lithium batteries has the problems of complicated process and long process. In addition, the extraction process also leads to problems such as large equipment area, high investment costs, and difficulty in organic wastewater treatment.

### SUMMARY

The present disclosure aims to solve at least one of the technical problems existing in the above-mentioned prior art. To this end, the present disclosure proposes a recovery method of valuable metal in positive electrode sheet of a lithium battery, which can achieve the purpose of omitting extraction and subsidiary steps thereof through simple impurity removal and separation procedures, simplifying the technological process and saving investment costs.

According to one aspect of the present disclosure, a recovery method of valuable metal in positive electrode sheet of a lithium battery is proposed, comprising steps of:
S1. calcinating after mixing the positive electrode sheet material with a reducing metal, wherein the calcinating is carried out under a protective atmosphere;
S2. performing magnetic separation on a material obtained in step S 1 to obtain a magnetic component and a non-magnetic component;
S3. dissolving the magnetic component in an acid, concentrating obtained leachate, and performing crystallization to obtain a metal salt A;
S4. leaching the non-magnetic component in water to obtain a sediment and a water leachate;
adding a carbonate into the water leachate to obtain lithium carbonate;
dissolving the sediment in an acid, purifying, and then performing crystallization from obtained dissolution solution to obtain a metal salt B.

The reaction mechanism of the recovery method proposed by the present disclosure is as follows:
In step S1, under the calcinating condition, the transition metal compound in the positive electrode sheet material is reduced by the reducing metal to the metal element. Combining with the transition metal material commonly used in the positive electrode material, it can be known that at least one of nickel, cobalt, and manganese element is expected to be generated;
Among them, nickel and cobalt are ferromagnetic, and manganese and other impurities are not ferromagnetic;
In step S2, through magnetic separation, the material obtained in step S1 can be divided into two parts, one is a magnetic component, which may include at least one of nickel and cobalt elements, and the other is a non-magnetic component, which may contain manganese element and other impurities;
Step S3 is a conventional leaching and crystallization process. Since the magnetic component hardly contains impurities, metal salt A (which may be at least one of nickel salt and cobalt salt) can be obtained by crystallization without an additional impurity removal step;
In step S4, since the lithium compound is almost completely soluble in water, it can be extracted by leaching in water;
Subsequent dissolution in an acid can leach the metal component in the sediment, mainly including manganese and other metal impurities; therefore, it requires a purification step and recrystallization to obtain metal salt (mainly manganese salt).

According to a preferred embodiment of the present disclosure, it has at least the following beneficial effects:
(1) In step S1 of the present disclosure, the transition metal in the positive electrode sheet material is reduced to elementary substance through reductive calcinating, so there is no need to add a reductant in the subsequent leaching (dissolving in an acid) process, leading to milder leaching conditions and higher leaching efficiency.
(2) In the present disclosure, through the reductive calcinating in step S1, the magnetic separation in step S2, and the purification in step S4, the transition metal can be simply recovered from the positive electrode material, and the extraction and subsequent back-extraction steps that must be used in the traditional hydro metallurgy process are omitted, which significantly shorten the recycling process and improve the efficiency of transition metal recycling.
(3) The present disclosure utilizes the property of co-crystallization of nickel sulfate and cobalt sulfate to directly concentrate the leachate obtained in step S3 and perform cooling crystallization, and high-purity nickel-cobalt binary sulfate crystals are obtained, which can be used for subsequent synthesis of precursor material, shortening the recycling process and improving the efficiency of metal recycling.
(4) After the calcinating in step S1, the lithium in the positive electrode material is converted into lithium oxide. After adding water to make pulp, the lithium oxide can be leached out, while other substances are insoluble, so that the purpose of selective lithium extraction is achieved;
   In step S4, lithium is first extracted to avoid loss of lithium in the subsequent purification process.
(5) In summary, with the advantages of simple operation, low production costs, stability and reliability, the recovery method provided by the present disclosure is suitable for industrial production, and has high recovery rates of lithium, nickel, cobalt and manganese metals, which has extremely high production benefits.

In some embodiments of the present disclosure, for the recovery method, steps S3 to S4 may be interchanged, or may be performed simultaneously.

In some embodiments of the present disclosure, in step S1, the positive electrode sheet material comprises at least one of lithium nickel-cobalt manganate, lithium nickelate, lithium cobaltate, lithium manganate, and lithium nickel-cobalt aluminate.

In some preferred embodiments of the present disclosure, in step S1, the positive electrode sheet material comprises lithium nickel-cobalt manganate.

In some preferred embodiments of the present disclosure, in step S1, the positive electrode sheet material is derived from at least one of lithium-ion batteries (cycled or not cycled), lithium metal batteries (cycled or not cycled) and scrap positive electrode active powder (homogenized or unhomogenized).

In some embodiments of the present disclosure, in step S1, the shape of the positive electrode sheet material is at least one of sheet, block, and powder.

Since powder can improve the contact between materials, in some preferred embodiments of the present disclosure, in step S1, the shape of the positive electrode sheet material is powder.

In some embodiments of the present disclosure, the method for obtaining the powdery positive electrode sheet material comprises the processes of crushing, sorting and screening the positive electrode sheet of lithium batteries in sequence.

In some embodiments of the present disclosure, in step S1, the reducing metal comprises at least one of magnesium and aluminum.

In some embodiments of the present disclosure, in step S1, a mass ratio of the reducing metal to the positive electrode sheet material is 0.4∼1.2:1.

In some preferred embodiments of the present disclosure, in step S1, a mass ratio of the reducing metal to the positive electrode sheet material is 0.5∼1:2:1.

In some preferred embodiments of the present disclosure, in step S1, a mass ratio of the reducing metal to the positive electrode sheet material is 0.4∼1.0:1.

In some embodiments of the present disclosure, in step S1, a temperature of the calcinating is 300~600°C.

In some preferred embodiments of the present disclosure, in step S1, a temperature of the calcinating is 400~600°C.

In some embodiments of the present disclosure, in step S1, a duration of the calcinating is 2~5 h.

In some preferred embodiments of the present disclosure, in step S1, a duration of the calcinating is 2~4 h.

In some embodiments of the present disclosure, in step S1, a heating rate of the calcinating is 1~5°C/min.

In some embodiments of the present disclosure, in step S1, a heating starting point of the calcinating is room temperature (10~40°C).

In some embodiments of the present disclosure, in step S1, the protective atmosphere comprises at least one of nitrogen, helium and argon.

In some embodiments of the present disclosure, in step S2, a magnetic field strength of the magnetic separation is 10∼30 T.

In some embodiments of the present disclosure, in step S2, the non-magnetic component comprises at least one of the reducing metal, lithium compound and manganese element.

In some embodiments of the present disclosure, in step S3, before dissolving in an acid, it further comprises mixing and pulping the magnetic component and water.

In some embodiments of the present disclosure, for the mixing and pulping, a ratio of the magnetic component to water is 1 g: 3∼5 mL.

In some embodiments of the present disclosure, in step S3, the acid used for dissolving in an acid is sulfuric acid.

In some embodiments of the present disclosure, in step S3, for dissolving in an acid, a molar ratio of hydrogen ions in the acid to the magnetic component is 2.2∼3:1.

In the process of dissolving in an acid, the reaction that occurs is shown in the following formula:
M+2H⁺→M²⁺+H₂↑; where M represents a transition metal in the magnetic component, and M²⁺ represents the +2-valent transition metal cation generated after dissolving in an acid.

According to the above formula, the theoretical molar ratio of hydrogen ions in the acid to the magnetic component is 2:1; the ratio of 2.2∼3:1 in the present disclosure is actually a slight excess of the acid to ensure that the magnetic component is completely dissolved.

In some embodiments of the present disclosure, in step S3, a pH of the leachate is 4~6.

In some preferred embodiments of the present disclosure, in step S3, a pH of the leachate is 4~5.5.

In some embodiments of the present disclosure, a reagent for adjusting the pH of the leachate is sodium carbonate solution.

In some embodiments of the present disclosure, in step S3, after the concentration, the total concentration of the metal in the leachate is 120∼220 g/L.

In some preferred embodiments of the present disclosure, in step S3, after the concentration, the total concentration of the metal in the leachate is 150∼220 g/L.

In some embodiments of the present disclosure, in step S3, a method of the concentration is heating and evaporation.

In some embodiments of the present disclosure, in step S3, the crystallization is at least one of cooling crystallization and evaporative crystallization.

In some embodiments of the present disclosure, a temperature of the cooling crystallization is 30~55°C.

In some embodiments of the present disclosure, a duration of the cooling crystallization is 5∼24 h.

In some preferred embodiments of the present disclosure, a duration of the cooling crystallization is 5~16 h.

In some embodiments of the present disclosure, the cooling crystallization is performed in a crystallization tank.

In some embodiments of the present disclosure, the method further comprises performing solid-liquid separation after the cooling crystallization to obtain a crystallized product of the metal salt A.

In some embodiments of the present disclosure, the metal salt A comprises at least one of nickel sulfate and cobalt sulfate.

In some embodiments of the present disclosure, in step S4, for leaching in water, a ratio of the non-magnetic component to water is 1 g: 3∼5 mL.

In some embodiments of the present disclosure, in step S4, a pH for leaching in water is 6.0∼8.0.

In some embodiments of the present disclosure, a reagent for adjusting the pH of the water leachate is selected from at least one of an aqueous sulfuric acid solution, an aqueous aluminum salt solution, and an aqueous iron salt solution.

The aqueous sulfuric acid solution can provide hydrogen ions to reduce the pH of the water leaching system.

In some embodiments of the present disclosure, a concentration of the aqueous sulfuric acid solution is 2~6 wt%.

In some embodiments of the present disclosure, when adjusting the pH for leaching in water, a feeding rate of the aqueous sulfuric acid solution is 1.0∼2.5 mL/min.

In the aqueous aluminum salt solution and the aqueous iron salt solution, metal ions (Al³⁺ and Fe³⁺) will undergo a hydrolysis reaction to combine with hydroxide in water, thereby increasing the ratio of hydrogen ions in the system, and reducing the pH of the water leaching system.

In some embodiments of the present disclosure, the aluminum salt is at least one of aluminum sulfate, aluminum nitrate, and aluminum chloride.

In some embodiments of the present disclosure, a concentration of the aqueous aluminum salt solution is 10∼15 wt %.

In some embodiments of the present disclosure, a concentration of the aqueous iron salt solution is 10∼15 wt %.

In some embodiments of the present disclosure, the iron salt is at least one of ferric sulfate, ferric nitrate and ferric chloride.

In some embodiments of the present disclosure, when adjusting the pH for leaching in water, a feeding rate of the aqueous aluminum salt solution or the aqueous iron salt solution is 2.0∼5.0 mL/min.

In some embodiments of the present disclosure, a reagent for adjusting the pH for leaching in water is pumped into the water leaching system using a peristaltic pump.

In some embodiments of the present disclosure, in step S4, it further comprises washing the sediment 2~3 times, and the generated washing solution is combined with the water leachate to prepare the lithium carbonate.

The aluminum salt and the iron salt will undergo a hydrolysis reaction in the aqueous solution to generate corresponding ferric hydroxide and aluminum hydroxide, when the pH is 6-8, the ferric hydroxide and the aluminum hydroxide are insoluble in water. Therefore, the introduced aluminum and iron impurities can be removed by simple solid-liquid separation.

In some embodiments of the present disclosure, in step S4, the carbonate comprises sodium carbonate.

In some embodiments of the present disclosure, in step S4, it further comprises pulping at a ratio of the sediment: water = 1 g: 3~5 ml before dissolving in an acid.

In some embodiments of the present disclosure, in step S4, the pH for dissolving in an acid is 1.0∼1.5.

In some embodiments of the present disclosure, in step S4, a reagent for adjusting the pH of the acid dissolving system is sulfuric acid.

In some embodiments of the present disclosure, in step S4, a temperature for dissolving in an acid is 60~80°C.

In some embodiments of the present disclosure, in step S4, a duration for dissolving in an acid is 2∼4 h.

In some embodiments of the present disclosure, in step S4, the purification comprises adjusting the pH of the acid dissolving system to 4.0~5.0 to remove aluminum; a pH adjusting agent used is sodium carbonate.

In some embodiments of the present disclosure, the aluminum removal comprises adjusting the pH to 4.0∼5.0 and then performing solid-liquid separation to obtain aluminum residue and a first dissolution solution.

In some embodiments of the present disclosure, the aluminum removal further comprises washing the aluminum residue 2∼3 times, and mixing the obtained washing solution with the first dissolution solution.

In some embodiments of the present disclosure, the recovery method further comprises preparing elementary aluminum from the aluminum residue, comprising steps of:
D1. adding pure water to the aluminum residue to make pulp, adjusting pH to 12~14 for reaction, and filtering;
D2. adjusting a pH of the filtrate obtained in step S1 to 6.0~8.0, and then filtering to obtain filter residue;
D3. calcinating the filter residue obtained in step D2 to obtain alumina;
D4. electrolyzing the alumina at a temperature of 900~1000°C using the alumina as a solute, cryolite (sodium hexafluoroaluminate, molten) as a solvent, carbon body as anode, and aluminum liquid as cathode to obtain the aluminum element.

In some embodiments of the present disclosure, in step D1, a reagent for adjusting the pH is 20∼30 wt% sodium hydroxide solution.

In some embodiments of the present disclosure, in step D1, a temperature of the reaction is 80~95°C.

In some embodiments of the present disclosure, in step D1, a duration of the reaction is 40∼60 min.

In some embodiments of the present disclosure, in step D2, a reagent for adjusting the pH is sulfuric acid.

In some embodiments of the present disclosure, in step D3, a temperature of the calcinating is 400~600°C.

In some embodiments of the present disclosure, in step D3, a duration of the calcinating is 2∼5 h.

In some embodiments of the present disclosure, in step D3, an atmosphere of the calcinating is air.

In the present disclosure, the aluminum residue obtained after aluminum removal can be electrolyzed to obtain elemental aluminum, through which not only the aluminum foil in the electrode sheet is recovered, but also the added aluminum powder can be recovered, thereby realizing the recycling of aluminum and improving the economy of the recovery method.

In some embodiments of the present disclosure, the purification further comprises performing magnesium removal treatment on the obtained first dissolution solution after the aluminum removal.

In some embodiments of the present disclosure, a reagent used in the magnesium removal is selected from sodium fluoride.

In some embodiments of the present disclosure, the magnesium removal further comprises performing a solid-liquid separation treatment after adding the sodium fluoride to obtain magnesium residue and a second dissolution solution.

In some embodiments of the present disclosure, the magnesium removal further comprises washing the magnesium residue 2~3 times with water, and mixing the obtained washing solution with the second dissolution solution to obtain the dissolution solution.

In some embodiments of the present disclosure, a method for the crystallization in step S4 comprises at least one of cooling crystallization and evaporative crystallization.

In some embodiments of the present disclosure, a method for the crystallization in step S4 and a method for the crystallization in step S3 may be the same or different.

In some preferred embodiments of the present disclosure, a method for the crystallization in step S4 is evaporative crystallization.

In some embodiments of the present disclosure, the metal salt B comprises manganese sulfate.

In some embodiments of the present disclosure, the recovery method further comprises preparing a positive electrode material precursor using the metal salt A and the metal salt B.

In some embodiments of the present disclosure, a preparation method of the positive electrode material precursor comprises dissolving the metal salt A and the metal salt B with pure water, adjusting the molar ratio of nickel, cobalt, and manganese in the system to a target ratio, then adding ammonia water and sodium hydroxide, adjusting the pH of the solution, and controlling the synthesis reaction temperature for co-precipitation reaction, and then filtering, washing, drying and screening the obtained solid.

### BRIEF DESCRIPTION OF DRAWINGS

The present disclosure will be further described below in conjunction with the accompanying drawings and examples, in which:

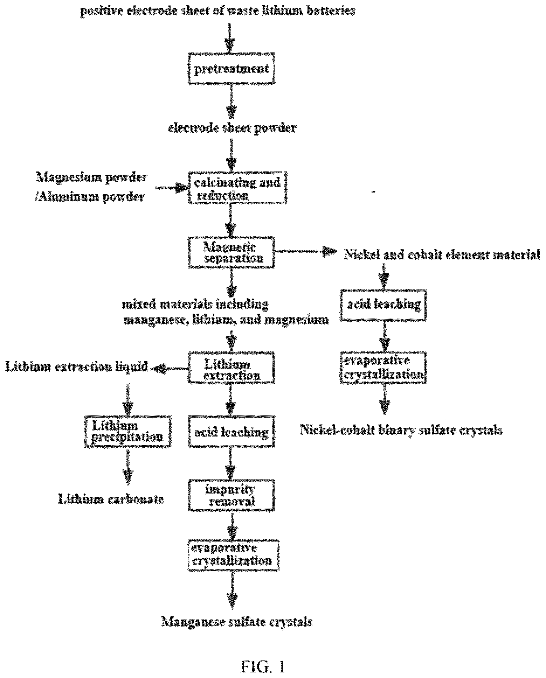

FIG. 1 is a schematic diagram of the reaction flow of Example 1 of the present disclosure.

### DETAILED DESCRIPTION

The concept of the present disclosure and the technical effects produced thereby will be clearly and completely described below in conjunction with the examples, so as to fully understand the purpose, features and effects of the present disclosure. Apparently, the described examples are only a part of the examples of the present disclosure, rather than all the examples. Based on the examples of the present disclosure, other examples obtained by those skilled in the art without creative efforts are all within the scope of protection of the present disclosure.

### Example 1

This example provides a recovery method of valuable metal in positive electrode sheet of a lithium battery, and the specific process was as follows:
A1. Pretreatment: The waste ternary positive electrode sheet of lithium batteries (from Guangdong Brunp Recycling Technology Co., Ltd., containing Ni 47.3%, Co 6.2%, Mn 5.9%, Li 7.2% in mass percentage) was subjected to crushing, sorting and screening processes in sequence to obtain electrode sheet powder.
A2. Deep reduction of aluminum powder:
A21. The electrode sheet powder obtained in step A1 was mixed uniformly with aluminum powder at a mass ratio of 1:0.5,
A22. The powder obtained in step A21 was placed in a tube furnace under a nitrogen atmosphere, heated at a heating rate of 1°C/min, from 25°C to 400°C, then calcinated for 4 h and cooled;
A3. Magnetic separation: The electrode sheet powder obtained in step A2 was subjected to magnetic separation with a magnetic separator under the condition of a magnetic field strength of 10 T to obtain magnetic nickel and cobalt elements powder (magnetic components) and non-magnetic mixed materials (non-magnetic components) including manganese, lithium (compound), aluminum (compound + element substance) and the like.
A4. Preparation of nickel-cobalt binary sulfate crystals:
A41. The magnetic component obtained in step A3 was added with pure water at a solid-liquid ratio of 1 g: 3 mL for pulping;
A42. The pulp obtained in step A41 was added with sulfuric acid for acid dissolution, wherein the molar ratio of sulfuric acid and magnetic component was 1.1:1;
A43. After the magnetic component was completely dissolved, sodium carbonate solution was added to the obtained nickel-cobalt solution to adjust the pH to 5.0;
A44. The pH-adjusted nickel-cobalt solution was evaporated to concentrate the total concentration of nickel and cobalt to 150 g/L, then the concentrated solution was transferred to a crystallization tank for cooling crystallization at 55°C for 16 h before centrifugation treatment to obtain high-purity nickel-cobalt binary sulfate crystals.

After detection, the recovery rate of nickel and cobalt was 99.5%. The recovery rate was calculated by the product of the mass of nickel-cobalt binary sulfate crystal and the mass content of nickel and cobalt in the nickel-cobalt binary sulfate crystal, divided by the mass of the electrode sheet powder in step A1, and then divided by the mass content of nickel and cobalt in the electrode sheet powder, wherein the method for determining the mass content of nickel and cobalt was ICP-OES; meanwhile, the mother liquor after crystallization can be recycled, and the calculation here was the overall result after multiple cycles, that is, the overall recovery rate of nickel and cobalt.
A5. Selective lithium extraction:
   A51. The non-magnetic component obtained in step A3 was added with pure water at a solid-liquid ratio of 1 g: 3 mL for pulping;
   A52. Under stirring, sulfuric acid with a concentration of 6 wt% was injected with peristaltic pump at flow rate of 1 mL/min, to adjust the pH of the pulp obtained in step A51 to 6.0, after that, stirring was continued for 30 min and filtration was performed to obtain filter residue and water extract;
   A53. The filter residue obtained in step A52 was washed with pure water, and the washing solution was added to the water extract;
      The specific operation of washing was as follows: firstly, pure water was added to the filter residue at a solid-liquid ratio of 1 g: 3 mL for pulping, and stirred for 30 min. Then the filter residue and washing solution were obtained by filtration, and then the obtained filter residue was rinsed with pure water twice.
   A54. Sodium carbonate was added to the water extract obtained in step A53 to prepare battery-grade lithium carbonate;
A6. Preparation of manganese sulfate crystals:
   A61. The filter residue obtained in step A53 was added with pure water at a solid-liquid ratio of 1 g: 3 mL for pulping;
   A62. Under stirring, the pulp obtained in step A61 was added with sulfuric acid to adjust the pH to 1.0, and reacted at 80°C for 2 h;
   A63. The pulp obtained in step A62 was added with sodium carbonate solution to adjust the pH of the pulp to 5.5, and filtration was performed to obtain aluminum residue and manganese sulfate solution;
      The aluminum residue was washed twice with pure water, and the washing solution was combined into manganese sulfate solution;
   A64. The manganese sulfate solution obtained in step A63 was subjected to evaporative crystallization to prepare battery-grade manganese sulfate crystals.
A7. Preparation of elemental aluminum from aluminum residue:
   A71. The aluminum residue obtained in step A63 was added with pure water for pulping with a solid-liquid ratio of 1 g: 3 ml;
   A72. The pulp obtained in step A71 was added with 20 wt% sodium hydroxide solution and stirred at 80°C for 60 min. The pH of the reaction end point was adjusted to 14, and filtration was performed;
   A73. The solution obtained in step A72 was added with sulfuric acid to adjust pH to 6.0, and then filtered to obtain filter residue;
   A74. The filter residue obtained in step A73 was calcinated at 400°C for 5 h in a tube furnace under an air atmosphere to obtain alumina;
   A75. The alumina was electrolyzed at a temperature of 950°C with direct current using the alumina as a solute, cryolite as a solvent, carbon body as anode, and aluminum liquid as cathode to obtain aluminum element.
A8. Precursor synthesis:
   The nickel-cobalt binary sulfate crystals obtained in step A4 and the manganese sulfate crystals obtained in step A6 were dissolved with pure water, and the molar ratio of nickel, cobalt, and manganese in the system was adjusted to 5:2:3. Then ammonia water and sodium hydroxide were added to adjust the pH of the solution to 11.0, and the synthesis reaction temperature was controlled to 65°C. After the reaction was complete, by filtering, washing, drying, and screening to remove iron, and NCM5:2:3 type precursor material was prepared.

A schematic flowchart of this example is shown in FIG. 1, and some unnecessary steps are not shown in detail.

### Example 2

This example provides a recovery method of valuable metal in positive electrode sheet of a lithium battery, and the specific process was as follows:
A1. Pretreatment: The waste ternary positive electrode sheet of lithium batteries (provided by Guangdong Brunp Recycling Technology Co., Ltd., containing Ni 36.5%, Co 11.3%, Mn 12.4%, Li 7.1% in mass percentage) was subjected to crushing, sorting and screening processes in sequence to obtain electrode sheet powder.
A2. Deep reduction of aluminum powder:
   A21. The electrode sheet powder obtained in step A1 was mixed uniformly with aluminum powder at a mass ratio of 1:1.2,
   A22. The powder obtained in step A21 was placed in a tube furnace under a nitrogen atmosphere, heated at a heating rate of 5°C/min, from 25°C to 600°C, then calcinated for 2 h and cooled;
A3. Magnetic separation: The electrode sheet powder obtained in step A2 was subjected to magnetic separation with a magnetic separator under the condition of a magnetic field strength of 30 T to obtain magnetic nickel and cobalt elements powder (magnetic components) and non-magnetic mixed materials (non-magnetic components) including manganese, lithium (compound), aluminum (compound + element substance) and the like.
A4. Preparation of nickel-cobalt binary sulfate crystals:
   A41. The magnetic component obtained in step A3 was added with pure water at a solid-liquid ratio of 1 g: 3 mL for pulping;
   A42. The pulp obtained in step A41 was added with sulfuric acid for acid dissolution, wherein the molar ratio of sulfuric acid and magnetic component was 1.5:1;
   A43. After the magnetic component was completely dissolved, sodium carbonate solution was added to the obtained nickel-cobalt solution to adjust the pH to 5.5;
   A44. The pH-adjusted nickel-cobalt solution was evaporated to concentrate the total concentration of nickel and cobalt to 220 g/L. Then the concentrated solution was transferred to a crystallization tank for cooling crystallization at 30°C for 5 h before centrifugation treatment to obtain high-purity nickel-cobalt binary sulfate crystals,

In which, the total recovery rate of nickel and cobalt was 97%, and the calculation method refers to Example 1.
A5. Selective lithium extraction:
   A51. The non-magnetic component obtained in step A3 was added with pure water at a solid-liquid ratio of 1 g: 3 mL for pulping;
   A52. Under stirring, sulfuric acid with a concentration of 2 wt% was injected with peristaltic pump at flow rate of 2.5 mL/min, to adjust the pH of the pulp obtained in step A51 to 8.0. After that, stirring was continued for 30 min and filtration was performed to obtain filter residue and water extract;
   A53. The filter residue obtained in step A52 was washed with pure water, and the washing solution was added to the water extract;
      The specific operation of washing was as follows: firstly, pure water was added to the filter residue at a solid-liquid ratio of 1 g: 3 mL for pulping, and stirred for 40 min. Then the filter residue and washing solution were obtained by filtration, and then the obtained filter residue was rinsed with pure water twice.
   A54. Sodium carbonate was added to the water extract obtained in step A53 to prepare battery-grade lithium carbonate;
A6. Preparation of manganese sulfate crystals:
   A61. The filter residue obtained in step A53 was added with pure water at a solid-liquid ratio of 1 g: 3 mL for pulping;
   A62. Under stirring, the pulp obtained in step A61 was added with sulfuric acid to adjust the pH to 1.0, and reacted at 60°C for 4 h;
   A63. The pulp obtained in step A62 was added with sodium carbonate solution to adjust the pH of the pulp to 5.5, and filtration was performed to obtain aluminum residue and manganese sulfate solution;
      The aluminum residue was washed twice with pure water, and the washing solution was combined into manganese sulfate solution;
   A64. The manganese sulfate solution obtained in step A63 was subjected to evaporative crystallization to prepare battery-grade manganese sulfate crystals.
A7. Preparation of elemental aluminum from aluminum residue:
   A71. The aluminum residue obtained in step A63 was added with pure water for pulping with a solid-liquid ratio of 1 g: 3 ml;
   A72. The pulp obtained in step A71 was added with 20% sodium hydroxide solution and stirred at 95°C for 40 min. The pH of the reaction end point was adjusted to 13, and filtration was performed;
   A73. The solution obtained in step A72 was added with sulfuric acid to adjust pH to 6.5, and then filtered to obtain filter residue;
   A74. The filter residue obtained in step A73 was calcinated at 600°C for 2 h in a tube furnace under an air atmosphere to obtain alumina;
   A75. The alumina was electrolyzed at a temperature of 950°C with direct current using the alumina as a solute, cryolite as a solvent, carbon body as anode, and aluminum liquid as cathode to obtain aluminum element.
A8. Precursor synthesis:
   The nickel-cobalt binary sulfate crystals obtained in step A4 and the manganese sulfate crystals obtained in step A6 were dissolved with pure water, and the molar ratio of nickel, cobalt, and manganese in the system was adjusted to 6:2:2. Then ammonia water and sodium hydroxide were added to adjust the pH of the solution to 11.0, and the synthesis reaction temperature was controlled to 65°C. After the reaction was complete, by filtering, washing, drying, and screening to remove iron, and NCM6:2:2 type precursor material was prepared.

### Example 3

This example provides a recovery method of valuable metal in positive electrode sheet of a lithium battery, and the specific process is as follows:
A1. Pretreatment: The waste ternary positive electrode sheet of lithium batteries (from Guangdong Brunp Recycling Technology Co., Ltd., containing Ni 31.7%, Co 11.4%, Mn 16.5%, Li 7.1% in mass percentage) was subjected to crushing, sorting and screening processes in sequence to obtain electrode sheet powder.
A2. Deep reduction of aluminum powder:
   A21. The electrode sheet powder obtained in step A1 was mixed uniformly with aluminum powder at a mass ratio of 1:1,
   A22. The powder obtained in step A21 was placed in a tube furnace under a nitrogen atmosphere, heated at a heating rate of 2°C/min, from 25°C to 500°C, then calcinated for 3 h and cooled;
A3. Magnetic separation: The electrode sheet powder obtained in step A2 was subjected to magnetic separation with a magnetic separator under the condition of a magnetic field strength of 20 T to obtain magnetic nickel and cobalt elements powder (magnetic components) and non-magnetic mixed materials (non-magnetic components) including manganese, lithium (compound), aluminum (compound + element substance) and the like.
A4. Preparation of nickel-cobalt binary sulfate crystals:
   A41. The magnetic component obtained in step A3 was added with pure water at a solid-liquid ratio of 1 g: 3 mL for pulping;
   A42. The pulp obtained in step A41 was added with sulfuric acid for acid dissolution, wherein the molar ratio of sulfuric acid and magnetic component was 1.2:1;
   A43. After the magnetic component was completely dissolved, sodium carbonate solution was added to the obtained nickel-cobalt solution to adjust the pH to 5.0;
   A44. The pH-adjusted nickel-cobalt solution was evaporated to concentrate the total concentration of nickel and cobalt to 180 g/L. Then the concentrated solution was transferred to a crystallization tank for cooling crystallization at 45°C for 12 h before centrifugation treatment to obtain high-purity nickel-cobalt binary sulfate crystals,
A5. Selective lithium extraction:
   A51. The non-magnetic component obtained in step A3 was added with pure water at a solid-liquid ratio of 1 g: 3 mL for pulping;
   A52. Under stirring, sulfuric acid with a concentration of 4 wt% was injected with peristaltic pump at flow rate of 1.5 mL/min, to adjust the pH of the pulp obtained in step A51 to 7.0. After that, stirring was continued for 30 min and filtration was performed to obtain filter residue and water extract;
   A53. The filter residue obtained in step A52 was washed with pure water, and the washing solution was added to the water extract;
      The specific operation of washing was as follows: firstly, pure water was added to the filter residue at a solid-liquid ratio of 1 g: 3 mL for pulping, and stirred for 30 min. Then the filter residue and washing solution were obtained by filtration, and then the obtained filter residue was rinsed with pure water twice.
   A54. Sodium carbonate was added to the water extract obtained in step A53 to prepare battery-grade lithium carbonate;
A6. Preparation of manganese sulfate crystals:
   A61. The filter residue obtained in step A53 was added with pure water at a solid-liquid ratio of 1 g: 3 mL for pulping;
   A62. Under stirring, the pulp obtained in step A61 was added with sulfuric acid to adjust the pH to 1.0, and reacted at 70°C for 3 h;
   A63. The pulp obtained in step A62 was added with sodium carbonate solution to adjust the pH of the pulp to 5.5, and filtration was performed to obtain aluminum residue and manganese sulfate solution;
      The aluminum residue was washed twice with pure water, and the washing solution was combined into manganese sulfate solution;
   A64. The manganese sulfate solution obtained in step A63 was subjected to evaporative crystallization to prepare battery-grade manganese sulfate crystals.
A7. Preparation of elemental aluminum from aluminum residue:
   A71. The aluminum residue obtained in step A63 was added with pure water for pulping;
   A72. The pulp obtained in step A71 was added with 25 wt% sodium hydroxide solution and stirred at 85°C for 50 min. The pH of the reaction end point was adjusted to 14, and filtration was performed;
   A73. The solution obtained in step A72 was added with sulfuric acid to adjust pH to 7.0, and then filtered to obtain filter residue;
   A74. The filter residue obtained in step A73 was calcinated at 500°C for 3 h in a tube furnace under an air atmosphere to obtain alumina;
   A75. The alumina was electrolyzed at a temperature of 950°C with direct current using the alumina as a solute, cryolite as a solvent, carbon body as anode, and aluminum liquid as cathode to obtain elementary aluminum.
A8. Precursor synthesis:
   The nickel-cobalt binary sulfate crystals obtained in step A4 and the manganese sulfate crystals obtained in step A6 were dissolved with pure water, and the molar ratio of nickel, cobalt, and manganese in the system was adjusted to 8:1:1. Then ammonia water and sodium hydroxide were added to adjust the pH of the solution, and the synthesis reaction temperature was controlled. After the reaction was complete, by filtering, washing, drying, and screening to remove iron, and NCM8:1:1 type precursor material was prepared.

### Example 4

This example provides a recovery method of valuable metal in positive electrode sheet of a lithium battery, and the specific process is as follows:
B1. Pretreatment: The waste ternary positive electrode sheet of lithium batteries (from Guangdong Brunp Recycling Technology Co., Ltd., containing Ni 47.3%, Co 6.2%, Mn 5.9%, Li 7.2% in mass percentage) was subjected to crushing, sorting and screening processes to obtain electrode sheet powder.
B2. Deep reduction of magnesium powder:
   B21. The electrode sheet powder obtained in step B1 was mixed with magnesium powder at a mass ratio of 1:0.6;
   B22. The mixed powder obtained in step B21 was calcinated in a tube furnace under nitrogen atmosphere at a heating rate of 1.5°C/min, from 25°C to 450°C, then calcinated for 4 h and cooled;
B3. The powder obtained in step B22 was subjected to magnetic separation with a magnetic separator under the condition of a magnetic field strength of 15 T to obtain magnetic nickel and cobalt elements powder (magnetic components) and non-magnetic mixed materials (non-magnetic components) including manganese, lithium magnesium and the like;
B4. Preparation of nickel-cobalt binary sulfate crystals:
   B41. The magnetic component obtained in step B3 was mixed with pure water at a solid-liquid ratio of 1 g: 3 mL for pulping;
   B42. The pulp obtained in step B41 was added with sulfuric acid at a molar ratio of magnetic component to sulfuric acid of 1:1.1. After the magnetic component was completely digested, the obtained nickel-cobalt solution was added with sodium carbonate solution to adjust the pH to 5.0;
   B43. The nickel-cobalt solution obtained in step B42 was evaporated to concentrate the total concentration of nickel and cobalt to 180 g/L;
   B44. The solution obtained in step B43 was transferred to a crystallization tank for cooling crystallization at 50°C for 12 h before centrifugation treatment to obtain high-purity nickel-cobalt binary sulfate crystals, which were used as raw materials for synthesizing ternary precursors;
B5. Selective lithium extraction:
   B51. The non-magnetic component obtained in step B3 was added with pure water at a solid-liquid ratio of 1 g: 3 mL for pulping;
   B52. Under stirring, aluminum sulfate solution with a concentration of 15 wt% was injected with peristaltic pump at flow rate of 2 mL/min, to adjust the pH end point of the pulp to 6.0. After that, stirring was continued for 30 min and solid-liquid separation was performed to obtain sediment and filtrate;
   B53. The sediment obtained in step B52 was continued to be added with pure water at a solid-liquid ratio of 1 g: 3 mL for pulping and stirred for 30min. Then the solid-liquid separation was performed to obtain a sediment and a filtrate, and the sediment was rinsed twice with pure water;
   B54. The filtrate obtained in this step was combined, and soda was added to prepare lithium carbonate;
B6. Preparation of manganese sulfate crystals:
   B61. The sediment obtained in step B53 was added with water at a solid-liquid ratio of 1 g: 3 mL for pulping;
   B62. Under stirring, the pulp obtained in step B61 was added with sulfuric acid to adjust the pH to 1.0, and reacted at 80°C for 2 h;
   B63. The slurry obtained in step B62 was added with sodium carbonate to adjust the pH of the pulp to 5.0 to remove aluminum, and solid-liquid separation was performed;
   B64. The filtrate obtained in step B63 was added with sodium fluoride to remove magnesium, wherein the amount of substance of sodium fluoride was 3 times of the amount of substance of magnesium. Filtration was performed to obtain magnesium fluoride residue and manganese sulfate solution;
      The magnesium fluoride residue was washed twice with pure water, and the washing solution was combined into manganese sulfate solution;
   B65. The manganese sulfate solution obtained in step B64 was subjected to defluorination (adding aluminum sulfate for defluorination, Al³⁺+6F+3Na⁺→Na₃AlF₆↓, the addition amount was 1.3 times the theoretical amount of the fluorine reaction, and the pH of the reaction end point was adjusted with sodium carbonate solution to 5.5). Then evaporative crystallization was performed to prepare battery-grade manganese sulfate crystals;
B7. Precursor synthesis:
   The nickel-cobalt binary sulfate crystals obtained in step B4 and the manganese sulfate crystals obtained in step B6 were dissolved with pure water, and the molar ratio of nickel, cobalt, and manganese in the system was adjusted to 5:2:3. Then ammonia water and sodium hydroxide were added to adjust the pH of the solution to 11.0, and the synthesis reaction temperature was controlled. After the reaction was complete, by filtering, washing, drying, and screening to remove iron, NCM5:2:3 type precursor material was prepared.

### Example 5

This example provides a recovery method of valuable metal in positive electrode sheet of a lithium battery, and the specific process is as follows:
B1. Pretreatment: The waste ternary positive electrode sheet of lithium batteries (from Guangdong Brunp Recycling Technology Co., Ltd., containing Ni 47.3%, Co 6.2%, Mn 5.9%, Li 7.2% in mass percentage) was subjected to crushing, sorting and screening processes to obtain electrode sheet powder.
B2. Deep reduction of magnesium powder:
   B21. The electrode sheet powder obtained in step B1 was mixed with magnesium powder at a mass ratio of 1:1.0;
   B22. The mixed powder obtained in step B21 was calcinated in a tube furnace under nitrogen atmosphere at a heating rate of 5°C/min, from 25°C to 450°C, then calcinated for 2.5 h and cooled;
B3. The powder obtained in step B22 was subjected to magnetic separation with a magnetic separator under the condition of a magnetic field strength of 30 T to obtain magnetic nickel and cobalt elements powder (magnetic components) and non-magnetic manganese, lithium magnesium and other mixed materials (non-magnetic components);
B4. Preparation of nickel-cobalt binary sulfate crystals:
   B41. The magnetic component obtained in step B3 was mixed with pure water at a solid-liquid ratio of 1 g: 3 mL for pulping;
   B42. The pulp obtained in step B41 was added with sulfuric acid at a molar ratio of magnetic component to sulfuric acid of 1:1.3. After the magnetic component was completely digested, the obtained nickel-cobalt solution was added with sodium carbonate solution to adjust the pH to 5.0;
   B43. The nickel-cobalt solution obtained in step B42 was evaporated to concentrate the total concentration of nickel and cobalt to 200 g/L;
   B44. The solution obtained in step B43 was transferred to a crystallization tank for cooling crystallization at 30°C for 6 h before centrifugation treatment to obtain high-purity nickel-cobalt binary sulfate crystals, which were used as raw materials for synthesizing ternary precursors;
B5. Selective lithium extraction:
   B51. The non-magnetic component obtained in step B3 was added with pure water at a solid-liquid ratio of 1 g: 3 mL for pulping;
   B52. Under stirring, aluminum chloride solution with a concentration of 10 wt% was injected with peristaltic pump at flow rate of 5 mL/min, to adjust the pH end point of the pulp to 8.0. After that, stirring was continued for 30 min and solid-liquid separation was performed to obtain sediment and filtrate;
   B53. The sediment obtained in step B52 was continued to be added with pure water at a solid-liquid ratio of 1 g: 3 mL for pulping and stirred for 40min. Then the solid-liquid separation was performed to obtain a sediment and a filtrate, and the sediment was rinsed twice with pure water;
   B54. The filtrate obtained in this step was combined, and soda was added to prepare lithium carbonate;
B6. Preparation of manganese sulfate crystals:
   B61. The sediment obtained in step B53 was added with water at a solid-liquid ratio of 1 g: 3 mL for pulping;
   B62. Under stirring, the pulp obtained in step B61 was added with sulfuric acid to adjust the pH to 1.0, and reacted at 60°C for 4 h;
   B63. The slurry obtained in step B62 was added with sodium carbonate to adjust the pH of the pulp to 5.0 to remove aluminum, and solid-liquid separation was performed;
   B64. The filtrate obtained in step B63 was added with sodium fluoride to remove magnesium, wherein the amount of substance of sodium fluoride was 3 times of the amount of substance of magnesium. Filtration was performed to obtain magnesium fluoride residue and manganese sulfate solution;
      The magnesium fluoride residue was washed twice with pure water, and the washing solution was combined into manganese sulfate solution;
   B65. The manganese sulfate solution obtained in step B64 was subjected to defluorination (adding aluminum sulfate for defluorination, Al³⁺+6F⁻+3Na⁺→Na₃AlF₆↓, the addition amount was 1.3 times the theoretical amount of the fluorine reaction, and the pH of the reaction end point was adjusted with sodium carbonate solution to 5.5). Then evaporative crystallization was performed to prepare battery-grade manganese sulfate crystals;
B7. Precursor synthesis:
   The nickel-cobalt binary sulfate crystals obtained in step B4 and the manganese sulfate crystals obtained in step B6 were dissolved with pure water, and the molar ratio of nickel, cobalt, and manganese in the system was adjusted to 6:2:2. Then ammonia water and sodium hydroxide were added to adjust the pH of the solution to 11.0, and the synthesis reaction temperature was controlled to 65°C. After the reaction was complete, by filtering, washing, drying, and screening to remove iron, and NCM6:2:2 type precursor material was prepared.

### Example 6

This example provides a recovery method of valuable metal in positive electrode sheet of a lithium battery, and the specific process was as follows:
B1. Pretreatment: The waste ternary positive electrode sheet of lithium batteries (from Guangdong Brunp Recycling Technology Co., Ltd., containing Ni 47.3%, Co 6.2%, Mn 5.9%, Li 7.2% in mass percentage) was subjected to crushing, sorting and screening processes to obtain electrode sheet powder.
B2. Deep reduction of magnesium powder:
   B21. The electrode sheet powder obtained in step B1 and magnesium powder were mixed at a mass ratio of 1:0.8,
   B22. The mixed powder obtained in step B21 was calcinated in a tube furnace under nitrogen atmosphere at a heating rate of 2°C/min, from 25°C to 400°C, then calcinated for 3 h and cooled;
B3. The powder obtained in step B22 was subjected to magnetic separation with a magnetic separator under the condition of a magnetic field strength of 20 T to obtain magnetic nickel and cobalt elements powder (magnetic components) and non-magnetic mixed materials (non-magnetic components) including manganese, lithium magnesium and the like;
B4. Preparation of nickel-cobalt binary sulfate crystals:
   B41. The magnetic component obtained in step B3 was mixed with pure water at a solid-liquid ratio of 1 g: 3 mL for pulping;
   B42. The pulp obtained in step B41 was added with sulfuric acid at a molar ratio of magnetic component to sulfuric acid of 1:1.2. After the magnetic component was completely digested, the obtained nickel-cobalt solution was added with sodium carbonate solution to adjust the pH to 5.0;
   B43. The nickel-cobalt solution obtained in step B42 was evaporated to concentrate the total concentration of nickel and cobalt to 160 g/L;
   B44. The solution obtained in step B43 was transferred to a crystallization tank for cooling crystallization at 45°C for 15 h before centrifugation treatment to obtain high-purity nickel-cobalt binary sulfate crystals, which were used as raw materials for synthesizing ternary precursors;
B5. Selective lithium extraction:
   B51. The non-magnetic component obtained in step B3 was added with pure water at a solid-liquid ratio of 1 g: 3 mL for pulping;
   B52. Under stirring, ferric chloride solution with a concentration of 10 wt% was injected with peristaltic pump at flow rate of 2.5 mL/min, to adjust the pH end point of the pulp to 7.0. After that, stirring was continued for 30 min and solid-liquid separation was performed to obtain sediment and filtrate;
   B53. The sediment obtained in step B52 was continued to be added with pure water at a solid-liquid ratio of 1 g: 3 mL for pulping and stirred for 40min. Then the solid-liquid separation was performed to obtain a sediment and a filtrate, and the sediment was rinsed twice with pure water;
   B54. The filtrate obtained in this step was combined, and soda was added to prepare lithium carbonate;
B6. Preparation of manganese sulfate crystals:
   B61. The sediment obtained in step B53 was added with water at a solid-liquid ratio of 1 g: 3 mL for pulping;
   B62. Under stirring, the pulp obtained in step B61 was added with sulfuric acid to adjust the pH to 1.0, and reacted at 70°C for 3 h;
   B63. The slurry obtained in step B62 was added with sodium carbonate to adjust the pH of the pulp to 5.0 to remove aluminum, and solid-liquid separation was performed;
   B64. The filtrate obtained in step B63 was added with sodium fluoride to remove magnesium, wherein the amount of substance of sodium fluoride was 3 times of that of magnesium. Filtration was performed to obtain magnesium fluoride residue and manganese sulfate solution;
      The magnesium fluoride residue was washed twice with pure water, and the washing solution was combined into manganese sulfate solution;
   B65. The manganese sulfate solution obtained in step B64 was subjected to defluorination (adding aluminum sulfate for defluorination, Al³⁺+6F⁻+3Na⁺→Na₃AlF₆↓, the addition amount was 1.3 times the theoretical amount of the fluorine reaction, and the pH of the reaction end point was adjusted with sodium carbonate solution to 5.5). Then evaporative crystallization was performed to prepare battery-grade manganese sulfate crystals;
B7. Precursor synthesis:
   The nickel-cobalt binary sulfate crystals obtained in step B4 and the manganese sulfate crystals obtained in step B6 were dissolved with pure water, and the molar ratio of nickel, cobalt, and manganese in the system was adjusted to 8:1:1. Then ammonia water and sodium hydroxide were added to adjust the pH of the solution to 11.0, and the synthesis reaction temperature was controlled to 65°C. After the reaction was complete, by filtering, washing, drying, and screening to remove iron, and NCM8:1:1 type precursor material was prepared.

### Comparative Example 1

This comparative example provides a traditional recovery method of valuable metal in positive electrode sheet of a lithium battery, and the specific process was as follows:
T1. The waste ternary positive electrode sheet (from Guangdong Brunp Recycling Technology Co., Ltd., containing Ni 47.3%, Co 6.2%, Mn 5.9%, Li 7.2% in mass percentage) was subjected to crushing, sorting and screening processes to obtain electrode sheet powder;
T2. The electrode sheet powder obtained in step T1 was added with pure water at a solid-liquid ratio of 1 g: 5 ml for pulping, and then added with sulfuric acid and hydrogen peroxide for leaching; wherein the amount of sulfuric acid added was 2.0 times the amount of substance of nickel, cobalt and manganese in the electrode sheet powder, and the amount of hydrogen peroxide added was 1.0 time the amount of substance of nickel, cobalt, and manganese in the electrode sheet powder. Then sodium carbonate was added to adjust the pH to 5.0 to remove aluminum, and solid-liquid separation was performed to obtain the solution containing nickel, cobalt, manganese, and lithium;
T3. First, the manganese in the solution of nickel, cobalt, manganese, and lithium obtained in step T2 was extracted into an organic phase with P204 extractant, and the raffinate was the solution of nickel, cobalt and lithium. The organic phase was back-extracted with sulfuric acid to obtain manganese sulfate solution, which was then subjected to evaporative crystallization to prepare manganese sulfate crystals;
T4. The raffinate obtained in step T3 was extracted with P507 extractant to extract nickel and cobalt into an organic phase, and the raffinate was a solution containing lithium; the organic phase was back-extracted with sulfuric acid to obtain a nickel-cobalt sulfate solution, which was then subjected to evaporative crystallization to prepare the nickel-cobalt binary sulfate crystals;
T5. The raffinate obtained in step T4 was added with an alkali to prepare lithium carbonate product;
T6. The nickel-cobalt binary sulfate crystals obtained in step T4 and the manganese sulfate crystals in step T3 were dissolved with pure water, and the molar ratio of nickel, cobalt and manganese in the system was adjusted to 5:2:3. Then ammonia water and sodium hydroxide were added to adjust the pH of the solution, and the synthesis reaction temperature was controlled. After the reaction was complete, by filtering, washing, drying, and screening to remove iron, NCM5:2:3 type precursor material was prepared.

### Test example

In the first aspect of this test example, the components of the nickel-cobalt binary sulfate crystals obtained in Examples 1~6 and Comparative Example 1 (Example Steps A4, B4, Comparative Example Step T4) were tested, and the test method was ICP-OES. Test results are shown in Table 1:

**Table 1 Components of the nickel-cobalt binary sulfate crystals obtained in Examples 1~6 and**

| Comparative Example 1 | | | | | | | | | | | | | | |
|---|---|---|---|---|---|---|---|---|---|---|---|---|---|---|
| Product | Ni/% | Co/% | Impurity content/ppm | | | | | | | | | | | |
| | | | Mn | Li | Ca | Mg | Cu | Fe | Zn | Al | Na | Pb | Cr | Cd |
| Example 1 | 18.3 | 4.5 | 2 | 3 | 3 | 2 | 1 | 1 | <1 | 2 | 50 | <1 | <1 | <1 |
| Example 2 | 17.6 | 5.1 | 2 | 2 | 3 | 2 | 1 | 1 | <1 | 2 | 61 | <1 | <1 | <1 |
| Example 3 | 20.2 | 2.5 | 2 | 3 | 3 | 2 | 1 | 1 | <1 | 3 | 42 | <1 | <1 | <1 |
| Example 4 | 17.5 | 5.1 | 3 | 2 | 2 | 3 | 1 | 1 | <1 | 1 | 56 | <1 | <1 | <1 |
| Example 5 | 18.6 | 4.2 | 2 | 2 | 3 | 2 | 1 | 1 | <1 | 1 | 49 | <1 | <1 | <1 |
| Example 6 | 18.2 | 4.5 | 3 | 2 | 2 | 2 | 1 | 1 | <1 | 1 | 53 | <1 | <1 | <1 |
| Comparative Example 1 | 19.4 | 3.2 | 420 | 185 | 3 | 3 | 1 | 1 | <1 | 2 | 71 | <1 | <1 | <1 |

As can be seen from Table 1, the contents of impurities Mn, Li, Ca, Mg, Cu, and Fe in the nickel-cobalt binary sulfate crystals prepared in Examples 1~6 were less than 3 ppm, and the contents of Zn, Pb, Cr, and Cd were less than 1ppm, indicating that nickel-cobalt binary sulfate crystals were of high purity. However, the Mn and Li in the nickel-cobalt binary sulfate crystals prepared in Comparative Example 1 were as high as 420 ppm and 185 ppm, respectively, and the purity was significantly lower than that of the nickel-cobalt binary sulfate crystals prepared in Examples 1~6.

In the second aspect of this test example, the components of the manganese sulfate crystals obtained in Examples 1~6 and Comparative Example 1 (Example Step A6, Comparative Example Step T3) were tested, and the specific test method was ICP-OES. The specific results are shown in Table 2:

**Table 2 Components of the manganese sulfate crystals obtained in Examples 1~6 and Comparative Example 1**

| Product | Mn/% | Impurity content/ppm | | | | | | | | | | | | |
|---|---|---|---|---|---|---|---|---|---|---|---|---|---|---|
| | | Ni | Co | Li | Ca | Mg | Cu | Fe | Zn | Al | Na | Pb | Cr | Cd |
| Example 1 | 32.2 | 2 | 3 | 3 | 3 | 2 | 1 | 1 | <1 | 2 | 46 | <1 | <1 | <1 |
| Example 2 | 32.1 | 2 | 2 | 2 | 2 | 3 | 1 | 1 | <1 | 2 | 57 | <1 | <1 | <1 |
| Example 3 | 32.3 | 2 | 3 | 3 | 3 | 2 | 1 | 1 | <1 | 3 | 51 | <1 | <1 | <1 |
| Example 4 | 32.4 | 3 | 2 | 2 | 2 | 3 | 1 | 1 | <1 | 1 | 53 | <1 | <1 | <1 |
| Example 5 | 32.2 | 2 | 2 | 3 | 3 | 2 | 1 | 1 | <1 | 1 | 56 | <1 | <1 | <1 |
| Example 6 | 32.5 | 3 | 3 | 2 | 3 | 3 | 1 | 1 | <1 | 1 | 61 | <1 | <1 | <1 |
| Comparative Example | 31.5 | 2285 | 3469 | 260 | 3 | 3 | 1 | 1 | <1 | 2 | 68 | <1 | <1 | <1 |

As can be seen from Table 2, the contents of impurities nickel, cobalt and lithium in the manganese sulfate crystals prepared in Examples 1~6 were significantly lower than that of Comparative Example 1, indicating that the preparation methods of Examples 1~6 were significantly superior to Comparative Example 1. This is because when P204 was used to extract manganese, a part of nickel and cobalt would also be extracted into the organic phase, resulting in high contents of nickel and cobalt in the manganese sulfate solution after back-extraction, thus affecting the quality of manganese sulfate product after evaporative crystallization.

In the third aspect of this test example, the components of the lithium carbonate obtained in Examples 1~6 and Comparative Example 1 (Example Step A5, Comparative Example Step T5) were tested, and the specific test method was ICP-OES. The specific results are shown in Table 3:

**Table 3 Components of the lithium carbonate obtained in Examples 1~3 and Comparative Example 1**

| Product | Li/% | Impurity Content/ppm | | | | | | | | | | | | |
|---|---|---|---|---|---|---|---|---|---|---|---|---|---|---|
| | | Ni | Co | Mn | Ca | Mg | Cu | Fe | Zn | Al | Na | Pb | Cr | Cd |
| Example 1 | 18.4 | 2 | 3 | 2 | 2 | 3 | 1 | 1 | <1 | 2 | 36 | <1 | <1 | <1 |
| Example 2 | 18.3 | 2 | 2 | 3 | 2 | 3 | 1 | 1 | <1 | 2 | 41 | <1 | <1 | <1 |
| Example 3 | 18.6 | 2 | 3 | 2 | 3 | 2 | 1 | 1 | <1 | 3 | 35 | <1 | <1 | <1 |
| Example 4 | 18.5 | 3 | 2 | 3 | 2 | 3 | 1 | 1 | <1 | 2 | 38 | <1 | <1 | <1 |
| Example 5 | 18.3 | 2 | 3 | 2 | 2 | 2 | 1 | 1 | <1 | 2 | 42 | <1 | <1 | <1 |
| Example 6 | 18.4 | 2 | 2 | 2 | 2 | 3 | 1 | 1 | <1 | 3 | 39 | <1 | <1 | <1 |
| Comparative Example 1 | 18.5 | 2 | 2 | 2 | 3 | 3 | 1 | 1 | <1 | 2 | 52 | <1 | <1 | <1 |

As can be seen from Table 3, the components of the lithium carbonate obtained in Examples 1~3 and Comparative Example 1 were comparable.

To sum up, the recovery method provided by the present disclosure does not require impurity removal, and can prepare nickel-cobalt binary sulfate product through simple crystallization. For non-magnetic materials such as lithium and manganese, lithium is selectively extracted by adding water for pulping and then adjusting pH; after solid-liquid separation, lithium carbonate is prepared from the solution by adding soda, and the manganese sulfate product is prepared from residue after dissolving in an acid, removing impurities and then crystallizing. The whole process is only through simple chemical impurity removal and evaporative crystallization.

In Comparative Example 1, the nickel, cobalt, manganese, and lithium in the electrode sheet powder must be dissolved by adding with an acid and a reductant. First, chemical impurity removal is performed. Then the manganese is extracted into the organic phase with P204 extractant, and the raffinate is extracted with P507 extractant to extract nickel and cobalt into the organic phase. The raffinate after P507 extraction was degreased and then added with soda to prepare lithium carbonate. The manganese sulfate solution obtained after back-extraction of the P204 organic phase with sulfuric acid is degreased, and subjected to evaporative crystallization to prepared manganese sulfate. The nickel-cobalt sulfate solution obtained after back-extraction of the P507 organic phase with sulfuric acid is degreased, and subjected to evaporative crystallization to prepared nickel-cobalt binary sulfate product. In the whole process, extractant is used many times and each corresponding extraction needs to go through the steps of saponification, mixing, clarification, washing, back-extraction, and degreasing.

Therefore, on the whole, the comparative example is more complicated than the examples, and the purity of the obtained product is lower.

The examples of the present disclosure have been described in detail above in conjunction with the drawings. However, the present disclosure is not limited to the above-mentioned examples, and various modifications can be made without departing from the purpose of the present disclosure within the scope of knowledge possessed by those of ordinary skill in the art. In addition, in the case of no conflict, the examples of the present disclosure and the features in the examples may be combined with each other.

## Claims

1. A method of recovering valuable metal in positive electrode sheet of a lithium battery, comprising steps of:
S1. calcinating after mixing the positive electrode sheet material with a reducing metal, wherein the calcinating is carried out under a protective atmosphere;
S2. performing magnetic separation on a material obtained in step S1 to obtain a magnetic component and a non-magnetic component;
S3. dissolving the magnetic component in an acid, concentrating obtained leachate, and performing crystallization to obtain a metal salt A;
S4. leaching the non-magnetic component in water to obtain a sediment and a water leachate;
adding a carbonate into the water leachate to obtain lithium carbonate;
dissolving the sediment in an acid, purifying, and then performing crystallization on obtained dissolution solution to obtain a metal salt B.

2. The recovery method according to claim 1, wherein in step S1, the positive electrode sheet material comprises at least one of lithium nickel-cobalt manganate, lithium nickelate, lithium cobaltate, lithium manganate and lithium nickel-cobalt aluminate.

3. The recovery method according to claim 1, wherein in step S1, the reducing metal comprises at least one of magnesium and aluminum; a mass ratio of the reducing metal to the positive electrode sheet material is 0.4∼1.2:1.

4. The recovery method according to claim 1, wherein in step S1, a temperature of the calcinating is 300~600°C; preferably, a duration of the calcinating is 2∼5 h.

5. The recovery method according to claim 1, wherein in step S2, a magnetic field strength of the magnetic separation is 10∼30 T.

6. The recovery method according to claim 1, wherein in step S3, before dissolving in an acid, further comprising mixing and pulping the magnetic component and water; preferably, in step S3, for dissolving in an acid, a molar ratio of hydrogen ions in the acid to the magnetic component is 2.2∼3:1; preferably, a pH of the leachate is 4∼6.

7. The recovery method according to claim 1, wherein in step S3, after the concentration, a total metal concentration in the leachate is 120∼220 g/L; preferably, in step S3, the crystallization is at least one of cooling crystallization and evaporative crystallization.

8. The recovery method according to claim 1, wherein in step S4, for leaching in water, a ratio of the non-magnetic component to water is 1 g: 3~5 mL; preferably, a pH for leaching in water is 6.0∼8.0.

9. The recovery method according to claim 1, wherein in step S4, for dissolving in an acid, pH is 1.0~1.5; preferably, in step S4, a temperature of the dissolving in an acid is 60~80°C; preferably, in step S4, a duration of the dissolving in an acid is 2∼4 h.

10. The recovery method according to any one of claims 1 to 9, wherein the recovery method further comprises preparing a positive electrode material precursor using the metal salt A and the metal salt B.
